(19) Europäisches Patentamt
European Patent Office
Office européen des brevets

(11) Numéro de publication: **0 072 740 B1**

(12) **FASCICULE DE BREVET EUROPEEN**

(45) Date de publication du fascicule du brevet:
27.03.85

(51) Int. Cl.⁴: **H 01 J 37/16,** B 01 J 3/00,
B 23 K 15/00, H 01 J 37/315

(21) Numéro de dépôt: **82401493.0**

(22) Date de dépôt: **06.08.82**

(54) **Chambre à vide modulaire extensible.**

(30) Priorité: **13.08.81 FR 8115671**

(43) Date de publication de la demande:
**23.02.83 Bulletin 83/8**

(45) Mention de la délivrance du brevet:
**27.03.85 Bulletin 85/13**

(84) Etats contractants désignés:
**AT BE CH DE FR GB IT LI LU NL SE**

(56) Documents cités:
**FR - A - 2 020 017**
**FR - A - 2 063 958**
**US - A - 2 950 029**

**AUTOMATIC WELDING, vol. 23, no. 9, 11 septembre
1970, pages 53-60, Cambridge (GB); Z. SCHILLER et al.:
"Electron beam welding machines produced by the
manfred von ardenne institute"
ELECTRONIQUE INDUSTRIELLE, no. 104, juin 1967,
pages 467-472, Paris (FR); G. MORESSEE: "La
Technique du soudage sous vide partiel"**

(73) Titulaire: **CREUSOT-LOIRE, 42 rue d'Anjou,
F-75008 Paris (FR)**

(72) Inventeur: **Binard, Jean, 164 résidence du Lac Torcy,
F-71210 Montchanin (FR)**

(74) Mandataire: **Dupuy, Louis et al, CREUSOT-LOIRE 15 rue
Pasquier, F-75383 Paris Cedex 8 (FR)**

BUNDESDRUCKEREI BERLIN

## Description

La présente invention concerne une chambre à vide modulaire extensible pouvant être utilisée par exemple pour le soudage par faisceaux d'électrons.

Dans les installations de soudage par faisceaux d'électrons, les pièces à souder sont généralement placées dans une chambre étanche dans laquelle on réalise le vide. Cette chambre, appelée communément »chambre à vide«, doit avoir des dimensions supérieures à celles de l'ensemble de pièces à souder, et doit comporter une ouverture par laquelle on introduit les pièces à souder, et qui est refermée avant d'effecteur le vide à l'intérieur.

Dans de telles installations de soudage par faisceaux d'électrons, le temps nécessaire au pompage de la chambre est relativement long si l'on veut obtenir un vide poussé. Bien sûr, le pompage est d'autant plus long que le volume de la chambre est plus grand, et il convient donc de réaliser une chambre à vide de dimensions minimum. La chambre à vide doit donc avoir des dimensions supérieures à celles du plus grand ensemble de pièces à souder. Dans ces conditions, lorsque l'on veut souder une pièce de petites dimensions, la chambre à vide est alors nettement surdimensionnée, et le temps de pompage nécessaire est relativement long.

Il est possible de disposer, pour une même machine de soudage par faisceau d'électrons, de plusieurs chambres à vide de dimensions différentes, de façon à pouvoir adapter les dimensions de la chambre à vide en fonction de l'encombrement de la pièce à souder. Généralement, ces chambres à vide sont de forme parallélépipèdique et elles doivent avoir des dimensions différentes à la fois en longueur, en largeur et en hauteur si on veut qu'elles puissent s'adapter à des pièces de toute forme, et il faut donc un nombre de chambres assez grand.

On pourrait aussi imaginer une chambre à vide télescopique mais cette solution n'est pas valable car elle implique des problèmes presque insurmontables d'étanchéité et de rigidité. D'autre part, une telle chambre à vide ne serait extensible que selon une seule de ses dimensions.

Une chambre à vide pour le soudage par faisceaux d'électrons extensible dans une direction par insertion de modules additionels est connue de la demande de brevet FR-A-2 020 017.

Il apparait donc intéressant de constituer une chambre à vide qui puisse être extensible selon une ou plusieurs de ses dimensions et qui soit constituée d'un ensemble d'éléments modulaires pouvant être assemblés rigidement différentes façons pour constituer la chambre à vide de différentes dimensions.

La présente invention concerne donc une chambre à vide modulaire extensible.

Selon une caractéristique essentielle de cette invention, la chambre à vide modulaire extensible est constituée, d'une part d'une boîte rigide de forme parallélépipèdique faite en deux parties identiques séparables, le plan de séparation des deux parties de cette boîte passant à la fois par une ligne diagonale située sur une première face de la boîte et par une ligne diagonale située sur l'autre face de la boîte parallèle à cette première face, et comprend d'autre part au moins un cadre rigide pouvant venir s'intercaler entre les deux parties de ladite boîte afin de constituer ensemble une autre boîte rigide dont au moins une dimension est supériere à celle de ladite boîte initiale.

Selon une caractéristique avantageuse de l'invention, le ou les cadres rigides sont constitués soit de deux faces parallèles en forme de parallélogramme reliées par deux autres faces parallèles en forme de rectangle, soit de deux faces parallèles en forme de trapèze reliées par deux autres faces perpendiculaires en forme de rectangle.

D'autres avantages apparaîtront lors de la description détaillée qui va suivre et qui se réfère à un mode de réalisation donné à titre d'exemple non limitatif et représenté par les dessins annéxés.

La figure 1 est une vue en perspective éclatée d'une chambre à vide selon l'invention.

La figure 2 est une vue en perspective d'une première forme de cadre rigide.

La figure 3 est une vue en perspective d'une deuxième forme de cadre rigide.

La figure 4 est une vue en perspective d'une troisième forme de cadre rigide.

Les figure 5 à 10 sont des vues de face de divers assemblages possibles de la chambre à vide.

La figure 11 est une vue partielle en coupe selon D-D de la figure 5.

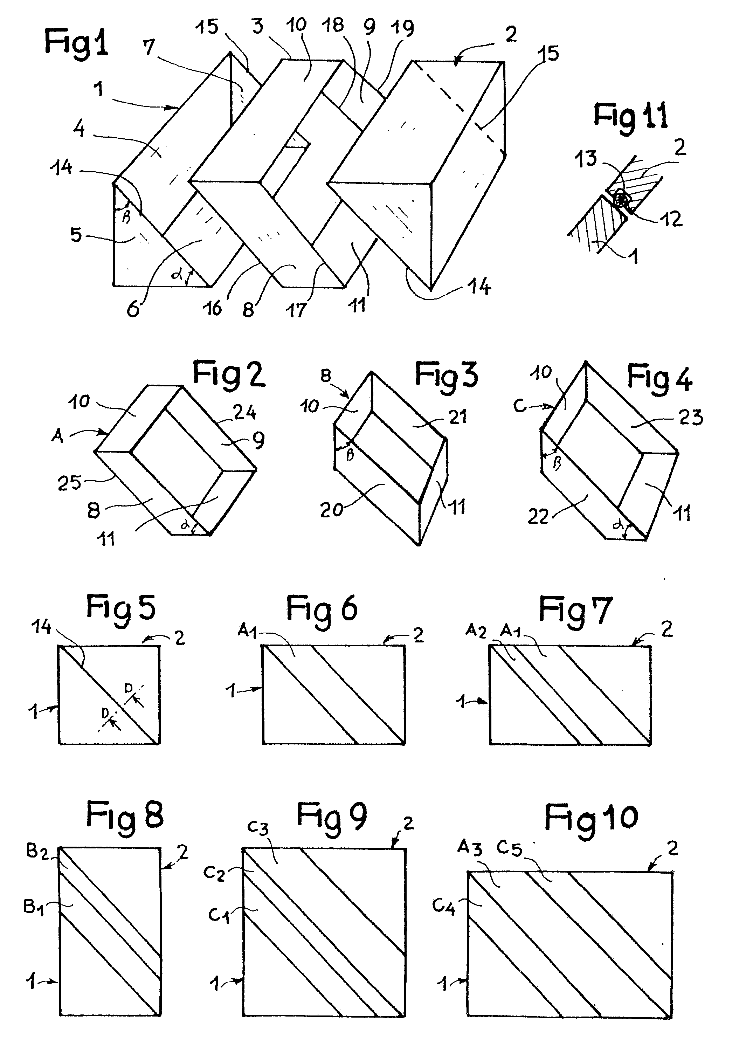

En se référant à la figure 1, on distingue trois pièces 1, 2, 3, qui constituent ensemble l'un des montages possibles de la chambre à vide. Il comprend en premier lieu une pièce 1 formant socle et une pièce 2 formant couvercle. Ces deux pièces 1, 2 sont de forme identique et sont constituées chacune d'une plaque horizontale rectangulaire 6 et d'une plaque verticale rectangulaire 4 reliée rigidement bord à bord à la plaque 6, et de deux plaques latérales 5, 7 en forme de triangle reliées rigidement, par leurs bords formant côtés de l'angle droit, respectivement aux bords latéraux des plaques 4 et 6 situés d'un côté et de l'autre. Ces deux pièces identiques 1, 2 ainsi constituées peuvent venir s'assembler, comme il est montré en figure 5, de façon à constituer une boîte rigide de forme parallélépipédique faite en deux pièces identiques 1, 2, séparables, le plan de séparation de la boîte passant par une ligne diagonale 14, 15 située sur l'une et l'autre des deux faces parallèles 5, 7 de la boîte.

Ce montage possible, représenté en figure 1, comprend aussi une pièce 3 en forme de cadre ridige, intercalée entre les deux pièces 1 et 2 afin de constituer ensemble une boîte rigide dont au moins une dimension est supérieure à celle de la boîte rigide formée uniquement des deux pièces 1 et 2. Bien sûr, le montage constitué des trois pièces 1, 2 et 3 ne constitue la chambre à vide que lorsque ces trois pièces sont assemblées bord à bord ensemble de façon étanche, les bords 14 et 15 de chaque pièce 1 et 2 venant en contact, respectivement, avec les bords 16, 17, 18 et 19 correspondants de la pièce 3.

Afin de constituer les chambres à vide de différentes dimensions, but de l'invention, on dispose d'un ensemble de pièces constitué d'une pièce 1 formant socle, d'une pièce 2 formant couvercle, ces pièces étant telles que décrites précédemment, et d'une pluralité de pièces intermédiaires 3 de formes et dimensions variables. Les chambres à vide de différentes dimensions que l'on peut construire à partir de cet ensemble comprennent d'une part obligatoirement le socle 1 et le couvercle 2, et d'autre part un certain nombre et une certaine combinaison de pièces intermédiaires 3 prises parmi les pièces 3 disponibles dans l'ensemble. Les différentes formes possibles de la pièce 3 sont représentées respectivement en figures 2, 3 et 4. La première forme A de la pièce 3, représentée en figure 2, constitue un cadre rigide composé de deux plaques rectangulaires identiques 10, 11 disposées parallèlement, reliées par leurs bords latéraux à deux plaques parallèles 8, 9 en forme de parallèlogramme, les deux bordures 24 et 25 de ce cadre étant située dans deux plans parallèles. Ce cadre A comporte une inclinaison $\alpha$ égale à l'inclinaison $\alpha$ du bord 14 du socle 1 (figure 1).

La deuxième forme B de la pièce 3, représentée en figure 3, est constituée de la même façon de deux plaques rectangulaires 10, 11 parallèles reliées par deux plaques parallèles 20, 21 en forme de parallèlogramme. L'angle $\beta$ formé sur ce cadre est égal à l'inclinaison $\beta$ du bord 14 par rapport à la verticale du socle 1 (figure 1).

La troisième forme C du cadre 3, représentée en figure 4, est constituée de deux plaques rectangulaires 10, 11 disposées perpendiculairement, reliées par deux plaques parallèles 22, 23 en forme de trapèze. L'angle $\alpha$ de ce trapèze étant égal, sur le socle 1, à l'inclinaison $\alpha$ du bord 14 par rapport à l'horizontale, et l'angle $\beta$ de ce trapèze étant égal, sur le socle 1, à l'inclinaison $\beta$ du bord 14 par rapport à la verticale.

Les figures 5 à 10 représentent différents exemples de construction possible pour la chambre à vide. La figure 5 représente la chambre à vide de volume minimum, constituée uniquement du socle 1 et du couvercle 2. La figure 6 représente une chambre à vide agrandie en largeur comprenant un cadre intermédiaire A1 dont la forme correspond à celle représentée en figure 2. La figure 7 montre une chambre à vide agrandie davantage en largeur, comprenant plusieurs cadres intermédiaires A1, A2. La figure 8 montre une chambre à vide agrandie uniquement en hauteur et comportant plusieurs cadres intermédiaires B1, B2, conformes au cadre B représenté en figure 3. La figure 9 montre une chambre agrandie à la fois en largeur et en hauteur comprenant plusieurs cadres C1, C2, C3 conformes au cadre C représenté en figure 4. La figure 10 montre une chambre à vide agrandie à la fois en largeur et en hauteur comprenant une association de cadres intermédiaires C4, C5 de forme correspondant au cadre C de la figure 4 et d'un cadre A3 de forme correspondant au cadre A de la figure 2. On voit, par les exemples de constructions de différentes chambres à vide montrés précédemment, que l'on peut constituer, à partir d'un socle 1, d'un couvercle 2, et d'un nombre relativement faible de cadres intermédiaires 3, à la manière d'un jeu de construction pour enfants, un nombre assez important de chambres à vide de dimensions variables à la fois en largeur et en hauteur.

Si, pour les pièces 1 et 2, on choisit un angle $\alpha$ et un angle $\beta$, tous les deux égaux à 45°, on voit aisément que les cadres de forme A et B sont alors en fait de même nature, le cadre B étant en fait un cadre A retourné, et on dispose alors dans ces conditions d'un nombre plus faible de pièces différentes permettant tout de même de réaliser un grand nombre de chambres à vide de dimensions différentes.

Mais bien sûr il est nécessaire de prévoir, sur les bords des différentes pièces 1, 2 et 3 venant en contact, des éléments d'étanchéité, tels que représentés en figure 11, de façon à ce que la chambre à vide ainsi constituée soit étanche. On peut par exemple ménager, sur certaines des bordures des pièces 1, 2 et 3 une rainure continue 13 dans laquelle vient se loger un joint torique 12.

D'autre part, il est bien évident que les pièces 1, 2 et 3 décrites précédemment, lorsqu'elles sont utilisées pour constituer des chambres à vide pour le soudage par faisceaux d'électrons doivent comporter tous les aménagements nécessaires à ce soudage, à savoir par exemple, le support et bridage des pièces à souder, le branchement des pompes, et le branchement de l'appareil soumettant l'intérieur de la chambre à un faisceau d'électrons.

L'invention ne se limite pas au mode de réalisation qui vient d'être décrit, elle en comporte au contraire toutes les variantes et l'on peut modifier les points de détail sans pour autant sortir du cadre de l'invention.

On peut remarquer que l'assemblage à la manière d'un jeu de construction des différentes chambres à vide à partir d'un ensemble de pièces 1, 2 et 3 donné n'est pas possible pour n'importe quelles pièces 3 prises parmi les pièces 3 disponibles dans l'ensemble. L'opérateur assemblant les pièces pour obtenir une chambre à vide donnée doit agencer les pièces intermédiaires 3 de façon que chaque bord (16 à 19) des pièces 3 venant en contact mutuel ait des dimensions identiques, et que chaque bord des pièces 3 ait des dimensions identiques au bord des pièces 1 ou 2 avec lequel il vient en contact, lors de l'assemblage.

On peut remarquer encore que si les pièces intermédiaires 3 sont toutes du type A ou B, leur nombre minimum dans un assemblage est de un (figure 6) si les pièces 3 sont toutes de type C, leur nombre minimum dans un assemblage est de deux (figure 9), et sie les pièces intermédiaires 3 sont des deux types A ou B et C, leur nombre minimum dans un assemblage est de 3 (figure 10), au moins deux pièces de type C et au moins une pièce de type A.

## Revendications

1. Chambre à vide modulaire extensible notamment pour le soudage par faisceaux d'électrons, caractérisée par le fait qu'elle est constituée:

— d'une boîte rigide de forme parallèlépipédique faite en deux parties (1, 2) identiques séparables, le plan de séparation de la boîte passant d'une part par une ligne diagonale (14) située sur une première face (5) de la boîte et d'autre part par une ligne diagonale (15) située sur la face (7) parallèle à ladite première face (5).
— et au moins d'un cadre rigide (3) pouvant venir s'intercaler entre les deux parties (1, 2) de ladite boîte afin de constituer ensemble une autre boîte rigide dont au moins une dimension est supérieure à celle de ladite boîte initiale.

2. Chambre à vide modulaire extensible selon la revendication 1, caractérisée par le fait que le ou les cadres rigides (3) sont constitués chacun de deux faces parallèles (8, 9) en forme de parallèlogramme reliées par deux autres faces (10, 11) parallèles en forme de rectangle.

3. Chambre à vide modulaire extensible selon la revendication 1 et comprenant au moins deux cadres rigides, caractérisée par le fait que le cadres rigides sont consitués chacun de deux faces parallèles (22, 23) en forme de trapèze reliées par deux autres faces (10, 11) perpendiculaires en forme de rectangle.

4. Chambre à vide modulaire extensible selon la revendication 1 et comprenant au moins trois cadres rigides, caractérisée par le fait qu'au moins un de ces cadres ridiges est constitué de deux faces parallèles en forme de parallèlogramme reliées par deux autres faces parallèles en forme de rectangle, et qu'au moins deux de ces cadres rigides sont constitués chacun de deux faces parallèles en forme de trapèze reliées par deux autres faces perpendiculaires en forme de rectangle.

5. Chambre à vide modulaire extensible selon l'une quelconque des revendications précédentes, caractérisée par le fait que les deux parties identiques (1, 2) séparables de la boîte rigide comportent des faces latérales (5, 7) en forme de triangle rectangle isocèle.

6. Chambre à vide modulaire extensible selon l'une quelconque des revendications précédentes, caractérisée par le fait qu'il est prévu des joints d'étanchéité (12) au niveau des contacts des pièces pouvant venir s'assembler.

## Patentansprüche

1. Modular bzw. bausteinartig erweiterbare Vakuumkammer, insbesondere zum Elektronenstrahlschweißen, dadurch gekennzeichnet, daß sie

— aus einem starren parallelepipedförmigen Gehäuse aus zwei identischen trennbaren Teilen (1, 2) besteht, wobei die Trennungsebene des Gehäuses einerseits durch eine diagonale Linie (14) auf einer ersten Fläche (5) des Gehäuses und anderseits durch eine diagonale Linie (15) verläuft, die auf der zur ersten Fläche (5) parallelen Fläche (7) gelegen ist, und
— wenigstens einen starren Rahmen (3) aufweist, der zwischen die beiden Teile (1, 2) des Gehäuses einsetzbar ist, um mit diesen zusammen ein anderes starres Gehäuse zu bilden, von welchem wenigstens eine Abmessung größer ist als die des ursprünglichen Gehäuses.

2. Modular bzw. bausteinartig erweiterbare Vakuumkammer nach Anspruch 1, dadurch gekennzeichnet, daß der oder die starre(n) Rahmen (3) jeweils von zwei parallelen Flächen (8, 9) in Form eines Parallelogrammes gebildet ist (sind), die durch zwei andere parallele Flächen (10, 11) in Form eines Rechteckes verbunden sind.

3. Modular bzw. bausteinartig erweiterbare Vakuumkammer nach Anspruch 1 mit wenigstens zwei starren Rahmen, dadurch gekennzeichnet, daß die starren Rahmen jeweils von zwei parallelen Flächen (22, 23) in Trapezform gebildet sind, die durch zwei andere, lotrechte Flächen (10, 11) in Rechteckform verbunden sind.

4. Modular bzw. bausteinartig erweiterbare Vakuumkammer nach Anspruch 1 mit wenigstens drei starren Rahmen, dadurch gekennzeichnet, daß wenigstens einer der starren Rahmen von zwei parallelen Flächen in Form eines Parallelogramms gebildet ist, die durch zwei andere parallele Flächen in Form eines Rechteckes verbunden sind, und daß wenigstens zwei dieser starren Rahmen jeweils aus zwei parallelen Flächen in Form eines Trapezes gebildet sind, die durch zwei andere lotrechte Flächen in Form eines Rechtecks verbunden sind.

5. Modular bzw. bausteinartig erweiterbare Vakuumkammer nach einem der vorhergehenden Ansprüche, dadurch gekennzeichnet, daß die beiden trennbaren identischen Teile (1, 2) des starren Gehäuses seitliche Flächen (5, 7) in Form eines rechteckigen gleichschenkligen Dreiecks aufweisen.

6. Modular bzw. bausteinartig erweiterbare Vakuumkammer nach einem der vorhergehenden Ansprüche, dadurch gekennzeichnet, daß sie mit Dichtungen (12) auf der Höhe der Berührungspunkte der zusammenbaubaren Teile versehen ist.

## Claims

1. Extensible modular vacuum chamber, particularly for electron beam welding, characterised by the fact that it is composed of:

— a rigid box of parallelepiped shape made in two identical separable parts (1, 2), the plane of separation of the box passing on the one hand through a diagonal line (14) situated on a first face (5) of the box and on the other hand through a diagonal line (15) situated on the face (7) parallel to the said first face (5),

— and at least one rigid frame (3) adapted to be interposed between the two parts (1, 2) of the said box to form together another rigid box of which at least one dimension is larger than that of the said original box.

2. Extensible modular vacuum chamber according to Claim 1, characterised by the fact that the rigid frame or frames (3) is or are each composed of two parallel parallelogram-shaped faces (8, 9) connected by two other parallel faces (10, 11) of rectangular shape.

3. Extensible modular vacuum chamber according to Claim 1 and comprising at least two rigid frames, characterised by the fact that the rigid frames are each composed of two parallel trapezium-shaped faces (22, 23) connected by two other faces (10, 11) which are perpendicular and of rectangular shape.

4. Extensible modular vacuum chamber according to Claim 1 and comprising at least three rigid frames, characterised by the fact that at least one of these rigid frames is composed of two parallel parallelogram-shaped faces connected by two other parallel faces of rectangular shape, and that at least two of these rigid frames are each composed of two parallel trapezium-shaped faces connected by two other faces which are perpendicular and rectangular in shape.

5. Extensible modular vacuum chamber according to any one of the preceding claims, characterised by the fact that the two identical separable parts (1, 2) of the rigid box have side faces (5, 7) in the shape of a right angled isosceles triangle.

6. Extensible modular vacuum chamber according to any one of the preceding claims, characterised by the fact that it is provided with seals (12) at the junctions of the parts which can be joined together.

Fig 1

Fig 11

Fig 2

Fig 3

Fig 4

Fig 5

Fig 6

Fig 7

Fig 8

Fig 9

Fig 10